(19) Europäisches Patentamt
European Patent Office
Office européen des brevets

(11) **EP 3 235 091 B1**

(12) **EUROPÄISCHE PATENTSCHRIFT**

(45) Veröffentlichungstag und Bekanntmachung des Hinweises auf die Patenterteilung:
**09.01.2019 Patentblatt 2019/02**

(21) Anmeldenummer: **15820053.5**

(22) Anmeldetag: **25.11.2015**

(51) Int Cl.:
*H02J 3/18* (2006.01)          *H02J 3/46* (2006.01)

(86) Internationale Anmeldenummer:
**PCT/EP2015/077673**

(87) Internationale Veröffentlichungsnummer:
**WO 2016/096355 (23.06.2016 Gazette 2016/25)**

(54) **SELEKTIVES PARALLELLAUFVERFAHREN FÜR MESS-/STEUERGERÄTE**

SELECTIVE PARALLEL RUNNING METHOD FOR MEASURING/CONTROL DEVICES

PROCÉDÉ DE FONCTIONNEMENT EN PARALLÈLE SÉLECTIF POUR APPAREILS DE MESURE/COMMANDE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.12.2014 DE 102014119158**

(43) Veröffentlichungstag der Anmeldung:
**25.10.2017 Patentblatt 2017/43**

(73) Patentinhaber: **Maschinenfabrik Reinhausen GmbH**
**93059 Regensburg (DE)**

(72) Erfinder:
• **ABELEN, Stefan**
**93142 Maxhütte-Pirkensee (DE)**
• **PREISSLER, Daniel**
**93083 Obertraubling (DE)**
• **ILGEVICIUS, Audrius**
**93059 Regensburg (DE)**
• **VIERECK, Karsten**
**93049 Regensburg (DE)**
• **WAGNER, Tobias**
**93059 Regensburg (DE)**
• **GRUBER, Tobias**
**93128 Regenstauf (DE)**

(56) Entgegenhaltungen:
DE-A1-102008 053 193     GB-A- 2 417 376
US-A1- 2009 089 608      US-A1- 2010 125 373

**Beschreibung**

Die vorliegende Erfindung bezieht sich auf ein selektives Parallellaufverfahren für Mess-/ und Steuergeräte. Das Verfahren dient der Parallellaufregelung von Transformatoren. Hierzu sind mehrere Transformatoren in einer Parallelschaltung angeordnet. Jedem der Transformatoren sind ein Mess-/Steuergerät und ein Stufenschalter zugeordnet. Alle Mess-/Steuergeräte der Stufenschalter sind über eine Kommunikationsverbindung miteinander verbunden.

Für die Parallelsteuerung von Stufentransformatoren haben sich im Wesentlichen zwei Verfahren durchgesetzt.

Das erste Verfahren, die sogenannte Gleichlaufsteuerung, kann nur bei Transformatoren gleicher Spannung, Leistung, Kurzschlussspannung, Stufenspannung und Stufenzahl durchgeführt werden. Bei diesem Verfahren müssen alle Transformatoren der jeweils parallelen Gruppe in der gleichen Betriebsstellung stehen. Dieses Verfahren, auch als "Master-Follower-Verfahren" bekannt, ist im Übrigen die einzige Methode für die Parallelsteuerung von Einphasen-Transformatoren in einer Drehstromgruppe.

Das zweite Verfahren, welches in der europäischen Patentanmeldung EP 2 389 723 A2 offenbart ist, arbeitet nach der sogenannten Kreisblindstrommethode. Diese Art der Parallellaufsteuerung wird hauptsächlich beim Parallellauf von Transformatoren mit unterschiedlicher Stufenzahl und unterschiedlichen Stufenspannungen angewendet. Das Verfahren zur Parallelsteuerung macht neben Spannungsreglern keine Zusatzgeräte mehr erforderlich, so dass auf stromführende Querverbindungen zwischen Messwandlern parallel laufender Transformatoren verzichtet werden kann. Ferner ist sichergestellt, dass aus dem Parallellauf genommene Transformatoren den Parallellauf der verbleibenden Transformatoren nicht beeinflussen und keine Änderungen bei den Einstellungen der Mess-/Steuergeräte erforderlich machen. Alle von den Strom- bzw.

Spannungswandlern erfassten Messwerte werden jetzt mathematisch abgeleitet. Dadurch ist es möglich, alle zur Steuerung von parallel laufenden Transformatoren notwendigen elektrischen Parameter mit sehr einfachen Wandlerschaltungen bereitzustellen. Die Verkabelung zwischen den Messwandlern und dem jeweiligen Mess-/Steuergeräte wird damit auf ein Minimum reduziert, so dass auch bei einer Parallelsteuerung von Transformatoren jeweils nur ein Strom- und ein Spannungswandler für jeden Transformator benötigt werden. Die Mess-/Steuergeräte der einzelnen Transformatoren sind alle über einen CAN-Bus miteinander verbunden. Die Messwerte werden somit zwischen den einzelnen Mess-/Steuergeräten untereinander ausgetauscht. Für den Fall, dass es zu einer Unterbrechung des CAN-Busses kommt, fährt die Parallelschaltung in einen Notbetrieb oder nimmt schlimmstenfalls die Parallelschaltung vom Netz.

Die internationale Patentanmeldung WO 93/17480 A1 offenbart eine Anordnung zur Spannungsregelung beim Parallelbetrieb von Transformatoren. Jeder Transformator weist einen Stufenschalter auf. Dieser ist mit einem mikroprozessorgesteuerten Digitalregler (Mess-/Steuergerät) verbunden, der die Stufenspannung regelt. Weiterhin weist jeder Digitalregler eine Schnittstelle auf, über welche die Digitalregler zu einem Ring verbunden sind und die Digitalregler die Mess- und Regelwerte über diesen Ring untereinander austauschen. Mit diesen Werten regeln sie den zwischen den Transformatoren fließenden Ausgleichsstrom auf ein Minimum. Die Stufenschalter der einzelnen Transformatoren werden automatisch in eine Betriebsstellung geführt, in der der Kreisblindstrom zwischen den Transformatoren ein Minimum erreicht.

Die europäische Patentanmeldung EP 0 482 361 A2 offenbart ein Verfahren zur Parallellaufregelung von Stufentransformatoren, die in beliebigen Schaltkombinationen auf ein Zweischienensammelsystem wirken. Dabei ist jedem Stufentransformator ein separater Regler zugeordnet, der auf den zugehörigen Motorantrieb einwirkt, der wiederum den zugehörigen Stufenschalter betätigt. Beim Verfahren wird in einem Parallelsteuergerät zuerst die aktuelle Transformatorenkonfiguration erfasst. Anschließend werden diesem Gerät die aktuellen Amplituden- und Phasenwerte von Spannung und Strom aller Stufentransformatoren übermittelt, woraus für jeden Stufentransformator der Teillaststrom und der Kreisblindstrom ermittelt und daraus eine Störgröße für die jeweiligen Mess-/Steuergeräte gebildet wird.

Die deutsche Patentschrift DE 40 04 671 C1 offenbart ein Verfahren zur selbsttätigen rechnergestützten Erkennung der Anlagenkonfiguration bei einer Vielzahl von an unterschiedliche Sammelschienen beliebig parallelgeschalteten Stufentransformatoren, die unterschiedliche Stufenzahlen und Spannungsstufen aufweisen können, sowie deren Regelung. Dabei erfassen jedem Stufentransformator zugeordnete Regler jeweils zyklisch die Wirk- und Blindanteile von Strom und Spannung. In einem Master-Regler wird die Zuordnung zwischen jeweiligem Transformator und entsprechender Sammelschiene getroffen. Anschließend werden nacheinander für alle Sammelschienen die Kreisblindströme der darauf geschalteten Transformatoren ermittelt. Schließlich werden die korrigierten Spannungswerte als neue Sollwerte an die Regler zurückgeführt.

Die deutsche Patentanmeldung DE 100 39 918 A1 offenbart eine selbstadaptierende Power-Factor-Regelung (PF-Regelung) zur Minimierung von durch parallel geschaltete Drehstromtransformatoren in Netzen entstehenden Kreisströmen. Die elektromotorische Kraft (EMK) der Transformatoren wird abhängig von einem ermittelten Wert verändert, der durch Vergleich des $\cos\phi$ am Einspeisepunkt jedes Transformators ($\cos\phi_{ist}$) mit einem Soll-$\cos\phi$ des Netzes ($\cos\phi_{soll}$) gewonnen wird, und wobei der einmalig bei der Einstellung der Kreisstrom-Minimierung korrekt eingegebene $\cos\phi_{soll}$ der darauf folgenden zeitlichen Veränderungen der Netzverhältnisse selbständig angepasst wird.

Die deutsche Patentanmeldung DE 10 2008 053 193 A1 offenbart ein Verfahren zur Parallellaufregelung von mehreren Transformatoren nach einleitendem Teil von Anspruch 1.

Der Erfindung liegt die Aufgabe zugrunde, ein Verfahren zur Parallellaufregelung von Transformatoren bei Ausfall der Kommunikation zwischen den Mess-/Steuergeräten und der den Transformatoren zugeordneten Stufenschaltern zu schaffen, so dass bei einem weiter laufenden Betrieb der parallelgeschalteten Transformatoren die Gefahr des Entstehens von zu hohen Kreisblindströmen, die zu einer Verlustleistung führen, verhindert ist.

Diese Aufgabe wird durch ein Verfahren gelöst, das die Merkmale des Anspruchs 1 umfasst.

Das erfindungsgemäße Verfahren zeichnet sich dadurch aus, dass zumindest ein Messwert des jeweiligen Mess-/Steuergeräts über die Kommunikationsverbindung an N-1 Mess-/Steuergeräte übertragen wird. An Hand der Messwerte der Mess-/Steuergeräte wird eine Berechnung einer Regelabweichung, die von einem Kreisblindstrom verursacht wird, für jedes Mess-/Steuergerät durchgeführt. Der Stufenschalter, der jedem Transformator zugeordnet ist, wird aufgrund der berechneten Regelabweichung derart betätigt, dass eine Minimierung des Kreisblindstroms für den jeweiligen Transformator durchgeführt wird. Für den Fall, dass die Kommunikationsverbindung unterbrochen ist, wird ein Fehlen eines Signals von mindestens einem der Mess-/Steuergeräte angezeigt und von allen übrigen Mess-/Steuergeräten festgestellt. Die für eine Minimierung eines Kreisblindstroms erforderliche Regelabweichung mindestens eines von der Unterbrechung der Kommunikationsverbindung betroffenen Transformators wird ermittelt. Dies geschieht an Hand der vor einem Zeitpunkt über die Kommunikationsverbindung empfangenen Messwerte, welche von dem zugeordneten Mess-/Steuergerät von zumindest einem weiteren Transformator übertragen wurden. Dabei ist dieses mindestens eine Mess-/Steuergerät nicht von der Unterbrechung betroffen. Bei dem von der Unterbrechung betroffenen Mess-/Steuergerät werden die eigenen, aktuell gemessenen Messwerte in die Ermittlung der Regelabweichung mit einbezogen.

Ein Vorteil des erfindungsgemäßen Verfahrens ist, dass der Regelprozess für die einzelnen Transformatoren der Parallelschaltung weiter läuft, und die den einzelnen Transformatoren zugeordneten Stufenschalter werden mit entsprechenden Steuersignalen versorgt, um den Kreisblindstrom für die einzelnen Transformatoren zu minimieren bzw. wenn möglich auf 0 zu bringen.

Die an jedem Mess-/Steuergerät der Parallelschaltung gemessenen Messwerte der jeweiligen Transformatoren sind in einer Ausführungsform ein sich mit der Zeit ändernder Wirkstrom und ein sich mit der Zeit ändernder Blindstrom.

Die Messwerte derjenigen Mess-/Steuergeräte, die durch die Unterbrechung der Kommunikationsverbindung isoliert sind, führen für die Zeitdauer der Unterbrechung die Berechnung der erforderlichen Regelabweichung zur Minimierung des Kreisblindstroms mit den eigenen aktuell gemessenen Messwerten und mit den zum Zeitpunkt der Unterbrechung als konstant geltenden, vor der Unterbrechung zuletzt übertragenen, Messwerten der übrigen Mess-/Steuergeräte durch. So bleibt eine Dynamik der Parallellaufregelung der Parallelschaltung aller Transformatoren der Parallelschaltung erhalten. Das durch die Unterbrechung betroffene Mess-/Steuergerät des "isolierten Transformators" übernimmt somit die letzten, von den jeweiligen Mess-/Steuergeräten der jeweiligen Transformatoren gemessenen (d.h. die an den "isolierten Transformator" übertragenen) Werte.

Eine Möglichkeit der Ausführung des Verfahrens ist, dass für den Fall der kompletten Unterbrechung der Kommunikation eines Mess-/Steuergeräts zu den anderen Mess-/Steuergeräten, dieses Mess-/Steuergerät die Methode der Kreisblindstromminimierung gemäß der Erfindung mit den letzten Messwerten der anderen Mess-/Steuergeräte weiterführt. So lange ein Mess-/Steuergerät noch eine Kommunikation zu mindestens einem weiteren Mess-/Steuergerät hat, werden diese die Methode der Kreisblindstromminimierung nur mit den noch kommunizierenden Mess-/Steuergeräten durchführen. Eventuell von einem Kommunikationsausfall weitere betroffene Mess-/Steuergeräte werden von den noch kommunizierenden Mess-/Steuergeräten nicht berücksichtigt.

Gemäß einer Ausführungsform des Verfahrens kann die Berechnung der Regelabweichung zur Minimierung des Kreisblindstroms bei denjenigen Mess-/Steuergeräten, die weiterhin über die Kommunikationsverbindung miteinander verbunden sind, mit den eigenen aktuell gemessenen Messwerten und den aktuell gemessenen Messwerten der übrigen, noch über die Kommunikationsverbindung verbundenen Mess-/Steuergeräte erfolgen.

Gemäß einer weiteren möglichen Ausführungsform des Verfahrens kann die Berechnung der Regelabweichung zur Minimierung des Kreisblindstroms bei denjenigen Mess-/Steuergeräten, die weiterhin über die Kommunikationsverbindung miteinander verbunden sind, mit den eigenen aktuell gemessenen Messwerten und den aktuell gemessenen Messwerten der übrigen, noch über die Kommunikationsverbindung verbundenen Mess-/Steuergeräte erfolgen. Ferner verwenden die weiterhin über die Kommunikationsverbindung miteinander verbunden Mess-/Steuergeräte die als konstant geltenden Messwerte der durch die Unterbrechung der Kommunikationsverbindung zum Zeitpunkt oder einer Abfolge von Zeitpunkten als isoliert geltenden Mess-/Steuergeräte.

Dies hat den Vorteil, dass eine größere Anzahl von Messwerten für die Berechnung der Regelabweichung zur Minimierung des Kreisblindstroms verwendet wird. So verwenden die Mess-/Steuergeräte aktuell gemessene Messwerte und ab einem Zeitpunkt der Parallelregelung konstant zu betrachtende Messwerte. Die konstant zu betrachtenden Messwerte stammen von dem mindestens einen Mess-/Steuergerät, das keine Kommunikationsverbindung mit den anderen Mess-/Steuergeräten der Parallelschaltung der Transformatoren hat. Die vor dem Zeitpunkt der Unterbrechung an die anderen Mess-/Steuergeräte gesendeten Messwerte werden für den weiteren Regelprozess verwendet. Sollten weitere Mess-/Steuergeräte die Kommunikationsverbindung zu den noch über die Kommunikationsverbindung verbundenen Mess-/Steuergeräten verlieren, so werden diejenigen Messwerte für den Regelprozess verwendet, die vor dem Zeitpunkt der Unterbrechung von den nun als isoliert zu betrachtenden Mess-/Steuergeräten gesendet wurden.

In einer weiteren Ausführungsform ist die Anzahl der in einer Parallelschaltung vorgesehenen Transformatoren größer oder gleich 2 und kleiner oder gleich 16.

Gemäß einer Ausführungsform des Verfahrens besteht das über die Kommunikationsverbindung übertragene Signal von den Mess-/Steuergeräten aus einem Bereitschaftssignal des jeweiligen Mess-/Steuergeräts und den Messwerten der jeweiligen Mess-/Steuergeräte. Dabei zeigt das Fehlen des Bereitschaftssignals und/oder das Fehlen der Messwerte vom jeweiligen Mess-/Steuergerät die Unterbrechung an. Dies deutet darauf hin, dass das von der Unterbrechung betroffene mindestens eine Mess-/Steuergerät isoliert ist und die von diesem Mess-/Steuergerät vor dem Zeitpunkt der Unterbrechung gesendeten Messwerte für den Regelprozess als konstant angenommen werden.

Das von den Mess-/Steuergeräten gesendete Bereitschaftssignal kann mit einer höheren oder einer gleichen Frequenz als die Sendefrequenz der Messwerte von den Mess-/Steuergeräten gesendet werden.

Der Vorteil der gegenwärtigen Erfindung ist, dass das Mess-/Steuergerät an einem Transformator [n] der Parallelschaltung nicht blockiert wird. Nur der [n-1] - Anteil an der Summe der Teilströme (der Blindstrom-Anteil wie auch der Wirkstrom-Anteil) wird als konstant betrachtet. Dies gilt jedoch nur für dasjenige Mess-/Steuergerät, das dem Transformator [n] direkt zugeordnet ist. Dieses Mess-/Steuergerät hat keine Kommunikation und bezieht nur den eigenen messbaren Anteil des Blindstroms $I_{Bi}$ und Wirkstroms $I_{Wi}$, wobei i = 1, ...N ist, in die Berechnung eines Phasenwinkels der Last mit ein.

Damit gilt:

$$I_{W1} + I_{W2} + I_{W3} + \ldots + I_{WN-1} + I_{WN} = \Sigma I_W \ ,$$

wobei $I_{W1} + I_{W2} + I_{W3} + \ldots + I_{WN-1}$ = *konst.*
und

$$I_{B1} + I_{B2} + I_{B3} + \ldots + I_{BN-1} + I_{BN} = \Sigma I_B \ ,$$

wobei $I_{B1} + I_{B2} + I_{B3} + \ldots + I_{BN-1}$ = *konst.* ist.

Infolgedessen wird eine Gefahr des Entstehens von Kreisblindströmen deutlich verringert, auch weil alle anderen Mess-/Steuergeräte nach der gleichen Berechnungsvorschrift arbeiten können und zumindest eine partielle Dynamik des Regelkreises erhalten bleibt.

Eine zusätzliche Überwachung des Spannungsbandes ist ein weiteres Mittel zur Absicherung des Betriebszustandes der parallel laufenden Transformatoren im Fall eines Ausfalls der Kommunikation.

Das Mess-/Steuergerät ist vorzugsweise als Spannungsregler eines Stufenschalters ausgebildet.

Nachfolgend sind die Erfindung und ihre Vorteile unter Bezugnahme auf die beigefügten Zeichnungen ausführlicher beschrieben. Es zeigen:

Figur 1 einen zeitlichen Verlauf der an einem Transformator einer Parallelschaltung gemessenen Spannung und der Regelspannung;

Figur 2 eine schematische Darstellung einer aus dem Stand der Technik bekannten Parallelschaltung von drei Transformatoren;

Figur 3 einen schematischen Ablauf des aus dem Stand der Technik bekannten Verfahrens zur Parallelsteuerung von mehreren Transformatoren mit Stufenschaltern;

Figur 4 eine schematische Darstellung zur Bestimmung des Winkels

$\varphi\Sigma$ des Vektors aus Gesamtwirkstrom und Gesamtblindstrom im elektrischen Zeigerdiagramm;

Figur 5 eine schematische Darstellung der Lastverhältnisse und die jeweils resultierende Regelabweichung bei Parallellauf von zwei Transformatoren; und

Figur 6 eine schematische Darstellung der Parallelschaltung von drei Transformatoren aus Figur 3, bei der das erfindungsgemäße Verfahren angewendet wird und nur das Mess-/Steuergerät des Stufenschalters des zweiten Transformators von einer Unterbrechung betroffen ist.

In den Figuren sind für gleiche oder gleich wirkende Elemente der Erfindung identische Bezugszeichen verwendet. Ferner sind der Übersicht halber nur Bezugszeichen in den einzelnen Figuren dargestellt, die für die Beschreibung der jeweiligen Figur erforderlich sind.

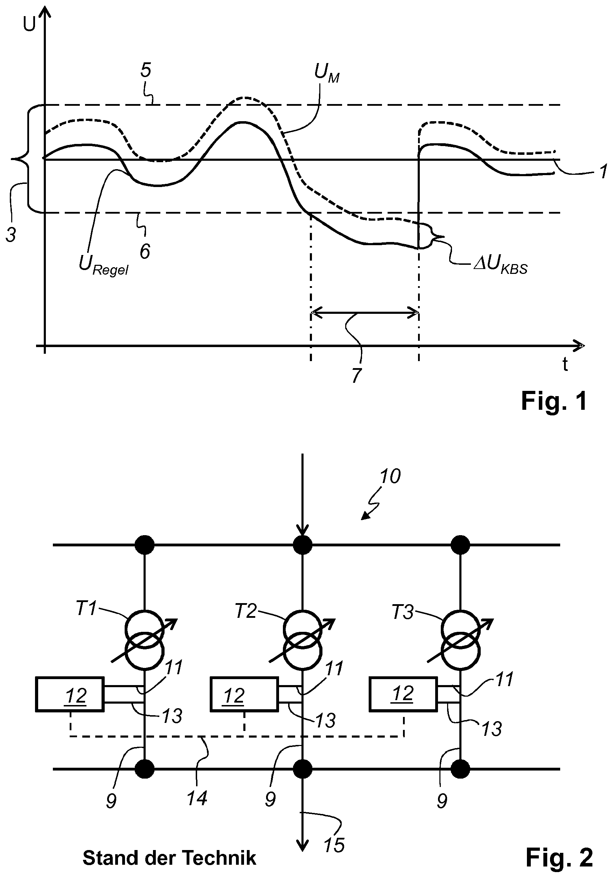

**Figur 1** zeigt einen zeitlichen Verlauf der gemessenen Spannung $U_M$ eines Transformators einer Parallelschaltung von Transformatoren, die über die Zeit gesehen in einem durch ein oberes Spannungsniveau 5 und ein unteres Spannungsniveau 6 definierten Intervalls 3 liegt. Zwischen dem oberen Spannungsniveau 5 und dem unteren Spannungsniveau 6 liegt ein Sollwert 1 der Spannung, um den die zu regelnde Spannung $U_{Regel}$ schwanken kann, ohne dass der Stufenschalter die Sekundärseite des Transformators eine oder mehrere Stufen höher schaltet oder die Sekundärseite des Transformators eine oder mehrere Stufen niedriger schaltet. Der Stufenschalter schaltet erst dann, wenn die zu regelnde Spannung $U_{Regel}$ für ein vordefiniertes Zeitintervall 7 das obere Spannungsniveau 5 überschreitet oder das untere Spannungsniveau 6 unterschreitet. Durch die Betätigung des Stufenschalters wird, wie in **Figur 1** gezeigt, die zu regelnde Spannung $U_{Regel}$ wieder in das Intervall 3 gebracht. Wie in **Figur 1** ebenfalls gezeigt, setzt sich die Regelspannung $U_{REGEL}$ aus der gemessenen Spannung $U_M$, einem Spannungsanteil $\Delta U_{KBS}$ aufgrund des Kreisblindstroms und einem Spannungskompensationsanteil $\Delta U_{KOMP}$ zusammen. Für die Regelspannung $U_{REGEL}$ gilt:

$$U_{REGEL} = U_M + \Delta U_{KBS} + \Delta U_{KOMP} \qquad \text{Gleichung (1)}$$

**Figur 2** zeigt eine schematische Darstellung einer Parallelschaltung 10 von drei Transformatoren T1, T2 und T3. Obwohl die nachfolgende Beschreibung für das erfindungsgemäße Verfahren drei Transformatoren betrifft, soll dies nicht als Beschränkung aufgefasst werden. Für einen Fachmann ist selbstverständlich, dass die Erfindung auch für eine beliebige Vielzahl von Transformatoren T1, T2,...TN von im Wesentlichen gleichen Typ Anwendung findet. Gemäß einer bevorzugten Ausführungsform sind mindestens 2 und maximal 16 Transformatoren parallel geschaltet. Jedem Abgang 9 eines jeden Transformators T1, T2 und T3 ist ein Mess-/Steuergerät 12 zugeordnet. Das Mess-/Steuergerät 12 führt eine Strommessung 11 und eine Spannungsmessung 13 am Abgang 9 eines jeden Transformators T1, T2 und T3 durch. Ferner sind die Mess-/Steuergeräte 12 der einzelnen Transformatoren T1, T2 und T3 über eine gemeinsame Kommunikationsverbindung 14 miteinander verbunden. Die Kommunikationsverbindung 14 kann beispielsweise ein CAN-Bus sein.

Die Messung von Strom und Spannung mit den jeweiligen Mess-/Steuergeräten 12 erfolgt nicht an Hand der tatsächlich anliegenden Spannung, beispielsweise 230 kV, und dem fließenden Strom von ca. 100 A. Es wird also zur Messung der Spannung ein "Voltage transformer" (nicht dargestellt) eingesetzt, der die Spannung von beispielsweise 230 kV auf beispielsweise 100V herabsetzt. Zur Messung des Stroms wird ein "Current transformer" (nicht dargestellt) eingesetzt, der den Strom von beispielsweise 100A auf beispielsweise 1A herabsetzt. Die Spannungswandlersekundärnennspannung $U_{VT\_SEC}$ und der Stromwandlersekundärnennstrom $I_{CT\_SEC}$ fließen in die weitere Berechnung ein.

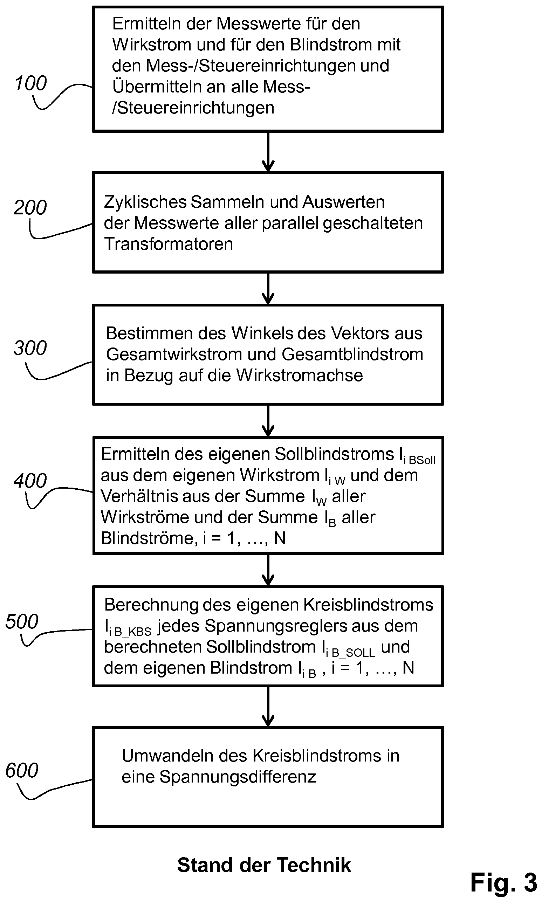

Zunächst soll das in **Figur 3** dargestellte Verfahren insgesamt erläutert werden. Mit der an Hand in **Figur 2** dargestellten Parallelverschaltung von drei Transformatoren T1, T2 und T3 wird die Parallelsteuerung durchgeführt, um den Blindstrom möglichst gering, annähernd auf Null, zu halten. Der Blindstrom ist dann Null, wenn die Winkel der Ströme aller Transformatoren gleich dem Winkel des Gesamtstroms sind. Das Verfahren besteht aus mehreren einzelnen Verfahrensschritten.

Zunächst werden in einem ersten Verfahrensschritt 100 von jedem Mess-/Steuergerät 12 eigene Messwerte für den Wirkstrom $I_{1W}$, $I_{2W}$ und $I_{3W}$ und für den Blindstrom $I_{1B}$, $I_{2B}$ und $I_{3B}$ ermittelt und den anderen Mess-/Steuergeräten 12 der anderen Transformatoren T1, T2 und T3 übermittelt.

In einem zweiten Verfahrensschritt 200 werden die Messwerte aller parallel geschalteten Transformatoren T1, T2 und T3 zyklisch gesammelt und ausgewertet. Für diesen Schritt des Verfahrens ist die Tatsache entscheidend, dass jedem parallel geschalteten Transformator T1, T2 und T3 ein eigenes Mess-/Steuergerät 12 zugeordnet ist, und dass alle Mess-/Steuergeräte 12 über die gemeinsame Kommunikationsverbindung 14, beispielsweise ein CAN-Bus, für den Informationsaustausch miteinander verbunden sind. Dieser sogenannte CAN-Bus (Controller Area Network) bietet neben einer hohen Übertragungsgeschwindigkeit bei einfachster Installation ein Höchstmaß an Übertragungssicherheit. Alle Mess-/Steuergeräte 12 können deshalb Informationen mit den anderen Mess-/Steuergeräten 12 der parallel geschalteten Transformatoren T1, T2 und T3 austauschen.

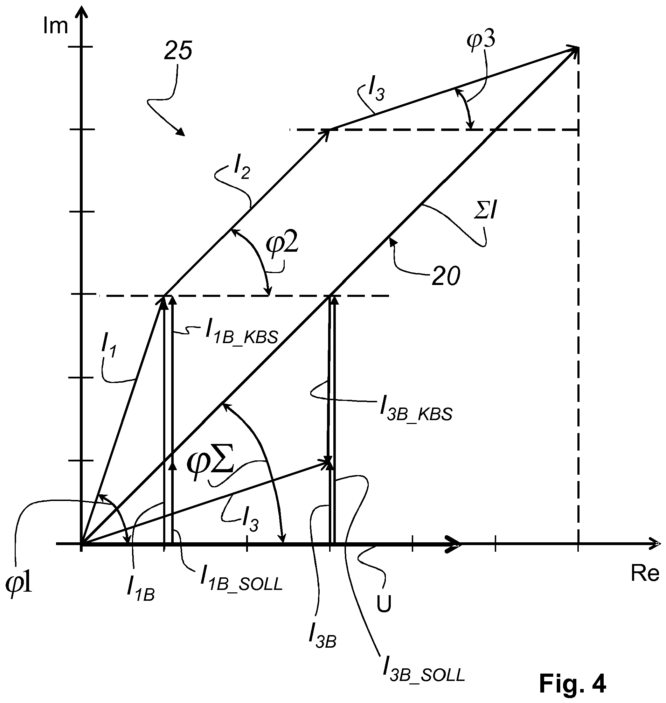

Anschließend wird in einem dritten Verfahrensschritt 300 aus den gesammelten Messwerten der Vektor 20 aus Gesamtwirkstrom und Gesamtblindstrom aller Transformatoren in das elektrische Zeigerdiagramm (siehe **Figur** 4) eingetragen. Der Vektor 20 schließt einen Winkel $\varphi\Sigma$ mit der X-Achse des elektrischen Zeigerdiagramms ein.

Jedes Mess-/Steuergerät 12 ermittelt die Summe $\sum I_W$ aller Wirkströme und die Summe $\sum I_B$ der Blindströme aller parallel geschalteten Transformatoren T1, T2 und T3.

$$I_{1W} + I_{2W} + I_{3W} + ... + I_{NW} = \sum I_W \qquad \text{Gleichung (2)}$$

und

$$I_{1B} + I_{2B} + I_{3B} + ... + I_{NB} = \sum I_B \qquad \text{Gleichung (3)}$$

Anschließend wird in einem vierten Schritt 400 von jedem Mess-/Steuergerät 12 der eigene Sollblindstrom $I_{1BSoll}$ aus dem eigenen Wirkstrom $I_{1W}$ und dem Verhältnis aus der Summe $\sum I_W$ aller Wirkströme und der Summe $\sum I_B$ aller Blindströme ermittelt.

$$\frac{I_{1BSOLL}}{I_{1W}} = \frac{\sum I_B}{\sum I_W} \qquad \text{Gleichung (4)}$$

$$I_{1BSOLL} = I_{1W} \times \frac{\sum I_B}{\sum I_W} \qquad \text{Gleichung (5)}$$

Unter der Annahme, dass sich beim Schalten eines Stufenschalters bei einem dieser parallel geschalteten Transformatoren T1, T2, ..., T3 beispielsweise nur der Blindstrom $I_{1B}$ durch den entsprechenden Transformator T1 ändert (die angeschlossene Last bleibt ja konstant) und das Mess-/Steuergerät 12 den Wirkstrom $I_{1W}$ des entsprechenden Transformators T1 kennt, kann jetzt die Höhe des Blindstroms $I_{1BSOLL}$ berechnet werden, der notwendig wäre, um zusammen mit dem gemessenen Wirkstrom $I_{1W}$ mit dem Vektor 20 aus Gesamtwirkstrom und Gesamtblindstrom parallel zu machen.

Im fünften Verfahrensschritt 500 erfolgt die Berechnung des eigenen Kreisblindstroms $I_{1B\_KBS}$ jedes Mess-/Steuergerätes 12 aus dem berechneten Sollblindstrom $I_{1B\_SOLL}$ und dem eigenen Blindstrom $I_{1B}$. Es sei hier nochmals erwähnt, dass die Berechnung hier und auch nachfolgend zwar speziell lediglich für i = 1 beschrieben ist, also für den Transformator T1, die Berechnung jedoch analog für alle Transformatoren T1, T2, ..., TN, i = 1, ..., N, der Parallelschaltung durchgeführt wird.

Als Ergebnis des vorangegangenen Verfahrensschritts 500 kennt das Mess-/Steuergerät 12 den Sollblindstrom $I_{1B\_SOLL}$, den die Last fordert, und den Beitrag des Blindstroms $I_{1B}$, den der zugeordnete Transformator T1 dazu liefert.

Aus der Differenz des Sollblindstroms $I_{1B\_SOLL}$ und des Blindstroms $I_{1B}$ des jeweiligen Transformators kann unter Berücksichtigung der Vorzeichen der beiden Ströme jetzt der Kreisblindstrom berechnet werden:

$$I_{1B\_KBS} = I_{1B} - I_{1B\_SOLL} \qquad \text{Gleichung (6.1)}$$

$$I_{2B\_KBS} = I_{2B} - I_{2B\_SOLL} \qquad \text{Gleichung (6.2)}$$

$$I_{3B\_KBS} = I_{3B} - I_{3B\_SOLL} \qquad \text{Gleichung (6.3)}$$

Die obigen Gleichungen verdeutlichen die Berechnung des jeweiligen Kreisblindstroms $I_{1B\_KBS}$, $I_{2B\_KBS}$ bzw. $I_{3B\_KBS}$ für die drei parallel geschalteten Transformatoren T1, T2 und T3 (siehe **Figur 2**).

Diese Differenz des Sollblindstroms $I_{1B\_SOLL}$ und des Blindstroms $I_{1B}$ des Transformators T1 ist der Kreisblindstrom $I_{1B\_KBS}$ und soll über die Betätigung des Stufenschalters am jeweils zugeordneten Transformator T1, T2,...,TN, hier konkret T1, minimiert werden. $I_{1B\_KBS}$ ist die Regelabweichung für den Transformator T1.

In einem sechsten Schritt 600 wird aus $I_{1B\_KBS}$ die Spannungsdifferenz $\Delta U_{KBS}$ durch Umrechnung abgeleitet.

Ist die Regelabweichung ungleich Null und überschreitet die Höhe der Regelabweichung einen vorgegebenen Grenzwert, so wird das Mess-/Steuergerät 12 den Stufenschalter veranlassen, dass dieser auf eine Position bzw. Anzapfung des jeweiligen Transformators fährt, auf der der Blindstrom $I_{1B}$ durch den Transformator T1 minimal, am besten Null, ist. Durch die Betätigung des Stufenschalters wird im Wesentlichen die induktive Komponente des durch den jeweiligen Transformator T1, T2, ..., TN fließenden Stroms beeinflusst. Dies bedeutet, dass eine Erhöhung und eine Absenkung der Längsimpedanz des jeweiligen Transformators T1, T2, ..., TN dem Kreisblindstrom $I_{1B\_KBS}$ entgegen-wirkt.

Bei der Betätigung des Stufenschalters werden Windungen der Regelwicklung zur Stammwicklung zu- bzw. von dieser abgeschaltet.

Da diese Regelabweichung von jedem der parallel geschalteten Mess-/Steuergeräte 12 für den jeweiligen Transformator T1, T2, T3 vorzeichenbehaftet berechnet wird, werden alle Mess-/Steuergeräte 12 ihre den Transformatoren T1, T2 oder T3 zugeordneten Stufenschalter veranlassen, auf eine Stufenschalterposition zu fahren, bei der der jeweilige Kreisblindstrom $I_{1B\_KBS}$, $I_{2B\_KBS}$ bzw. $I_{3B\_KBS}$ minimal, am besten Null, ist.

Dabei kann durchaus ein Stufenschalter auf eine höhere Stufenschalterstellung gefahren werden, während die anderen Stufenschalter auf eine niedrigere Position fahren.

Zur Darstellung des Winkels $\varphi\Sigma$ des Vektors 20 aus den gesammelten Messwerten aus Gesamtwirkstrom und Gesamtblindstrom in Bezug auf die X-Achse wird auf das in **Figur 4** offenbarte elektrische Zeigerdiagramm verwiesen. Hierzu werden Messwerte für den Wirkstrom für die drei Transformatoren T1, T2 und T2 die folgenden Werte (siehe Tabelle 1) für den jeweiligen Wirkstrom $I_W$ und den jeweiligen Blindstrom $I_B$ angenommen.

[Tabelle 1]

|  | Transformator T1 | Transformator T2 | Transformator T3 |
|---|---|---|---|
| $I_W$ [Wirkstrom)] | 1A | 2A | 3A |
| $I_B$ [Blindstrom] | 3A | 2A | 1A |

Somit ergibt sich, wie aus **Figur 4** ersichtlich ist, für die Summe $\Sigma I_W$ aller Wirkströme und die Summe $\Sigma I_B$ aller Blindströme jeweils der Wert von 6A. Das Ziel der Parallelregelung der Transformatoren T1, T2 oder T3 ist, die Anteile der jeweiligen Wirkströme $I_{1W}$, $I_{2W}$, oder $I_{3W}$ und die Anteile der jeweiligen Blindströme $I_{1B}$, $I_{2B}$, oder $I_{3B}$ derart zu verändern, dass deren Winkel zur Wirkstromachse W im elektrischen Zeigerdiagramm 25 den gleichen Wert annimmt. Bei der in **Figur 4** dargestellten Veranschaulichung ist $\varphi1 > \varphi\Sigma$, $\varphi2 = \varphi\Sigma$ und $\varphi3 < \varphi\Sigma$. Da mit den Stufenschaltern der Transformatoren T1, T2 oder T3 die Anzapfungen an den Transformatoren in Abhängigkeit von den gemessen Werten beschaltet werden, erreicht man die Anpassung bzw. Minimierung des Kreisblindstroms. Es kann eine Regelabweichung eines Stroms $\Delta I_{N\_KBS}$ für jedes Mess-/Steuergerät 12 eines Transformators T1, T2, ..., TN berechnet werden. Diese Regelabweichung ergibt sich somit aus der Betrachtung der einzelnen Ströme $I_1$, $I_2$, und $I_3$ insbesondere deren Vektoren im Zeigerdiagramm.

Als Ergebnis dessen fließt durch alle parallel geschalteten Transformatoren nach Abschluss des Regelvorganges immer ein minimaler Kreisblindstrom.

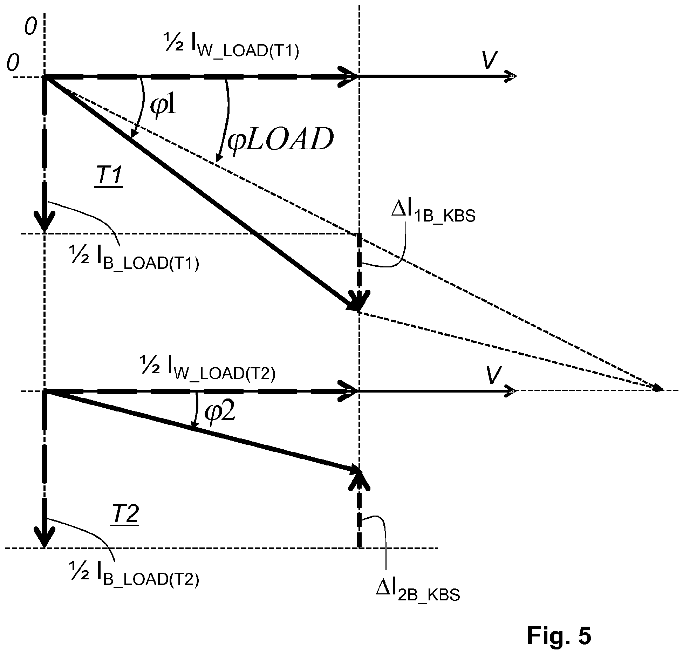

**Figur 5** zeigt eine schematische Darstellung der Lastverhältnisse und die jeweils resultierende Regelabweichung bei Parallellauf von zwei Transformatoren T1 und T2. Der Phasenwinkel $\varphi_{LOAD}$ (entspricht $\varphi\Sigma$ aus Fig. 4) an der Last 15 der Parallelschaltung der beiden Transformatoren T1 und T2 wird durch deren Eigenschaften vorbestimmt und kann durch das Mess-/Steuergerät 12 und den dazugehörigen Transformator T1 oder T2 nicht beeinflusst werden.

Der Stufenschalter der jedem Transformator T1 und T2 zugeordnet ist, beeinflusst als Längsregler im Wesentlichen lediglich die induktive Komponente (Blindstrom) des durch den Transformator T1 oder T2 fließenden Gesamtstroms. Dies ist bedingt durch die Beziehung, dass die induktive Komponente (Blindstrom) wesentlich größer als die aktive Komponente (Wirkstrom) ist.

Die Regelabweichung $\Delta I_{1B\_KBS}$ oder $\Delta I_{2B\_KBS}$ für das jeweilige Mess-/Steuergerät 12 des zugeordneten und parallellaufenden Transformators T1 oder T2 errechnet sich über die Betrachtung der Blindströme für jeden einzelnen Transformator T1 oder T2 :

$$\Delta I_{1B\_KBS} = I_{1B} - I_{1B\_SOLL}$$

Dabei errechnet sich $I_{1B\_SOLL}$ aus $\left(\dfrac{I_{1B} + I_{2B}}{I_{1W} + I_{2W}} \times I_{1W}\right)$ und dem induktiven Anteil (Blindstromanteil) des ersten Transformators T1.

Analog gilt:

$$\Delta I_{2B\_KBS} = I_{2B} - I_{2B\_SOLL}$$

Dabei errechnet sich $I_{2B\_SOLL}$ aus $\left( \dfrac{I_{1B} + I_{2B}}{I_{1W} + I_{2W}} \times I_{2W} \right)$ und dem induktiven Anteil (Blindstromanteil) des zweiten Transformators T2.

Die Regelabweichung wird dann am kleinsten (idealerweise gleich Null) sein, wenn der gemessene Phasenwinkel $\varphi 1$ bzw. $\varphi 2$ am ersten Transformator T1 bzw. am zweiten Transformator T2 gleich dem der Last $\varphi_{Load}$ (entspricht $\varphi\Sigma$ aus Fig. 4) der Parallelschaltung des ersten Transformators T1 bzw. des zweiten Transformators T2 ist.

Erreicht wird dies durch die Änderung der Längsimpedanz des jeweiligen Transformators T1 oder T2 durch den Stufenschalter, der jedem der Transformatoren T1 und T2 zugeordnet ist. Durch Betätigung des Stufenschalters werden Wicklungen einer Regelwicklung zu einer Stammwicklung zu- bzw. abgeschaltet.

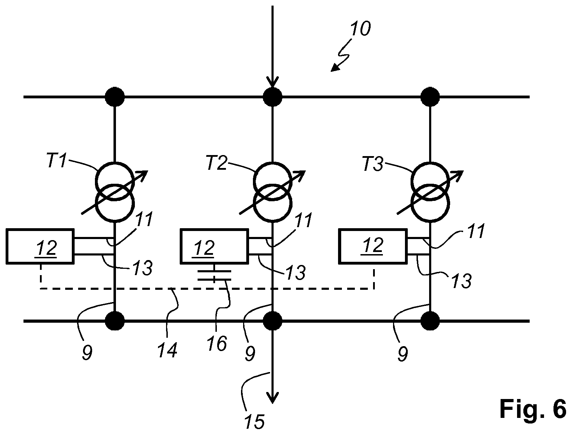

**Figur 6** zeigt eine schematische Darstellung der Parallelschaltung 10 von drei Transformatoren aus **Figur 3,** bei der das erfindungsgemäße Verfahren trotz einer Unterbrechung 16 der Kommunikationsverbindung 14 fortgesetzt wird. Über die Kommunikationsverbindung 14 erhält jedes der Mess-/Steuergeräte 12 der jeweiligen Transformatoren T1, T2 und T3 in regelmäßigen Zeitabständen Informationen über die Messwerte $I_W$ (Wirkstrom) und $I_B$ (Blindstrom) der übrigen Transformatoren T1, T2 bzw. T3. Im laufenden Betrieb wird dann, wie bereits oben erwähnt, an Hand der Messwerte die Parallelschaltung 10 der Transformatoren T1, T2 und T3 derart gesteuert, dass der Kreisblindstrom der einzelnen Transformatoren T1, T2 und T3 minimal, am besten gleich Null, wird. Jedes der Mess-/Steuergeräte 12 erhält über die Kommunikationsverbindung 14 die Information der anderen Mess-/Steuergeräte 12, die über die Kommunikationsverbindung 14 noch erreichbar sind. Hierzu senden sich alle Mess-/Steuergeräte 12 in bestimmten Zeitabständen ein Signal (Bereitschaftssignal). Kommt von einem oder mehreren Mess-/Steuergeräten 12 kein Signal mehr, so deutet dies an, dass der eine oder die mehreren Mess-/Steuergeräte 12 nicht mehr erreichbar sind und dass eine Unterbrechung 16 der Kommunikationsverbindung 14 vorliegt.

Bei der in **Figur 6** gezeigten Darstellung liegt die Unterbrechung 16 der Kommunikationsverbindung 14 beispielsweise am Mess-/Steuergerät 12 des zweiten Transformators T2 vor. Dies bedeutet, dass von dem Mess-/Steuergerät 12 des ersten Transformators T1 und von dem Mess-/Steuergerät 12 des dritten Transformators T3 keine Information an das Mess-/Steuergerät 12 des zweiten Transformators T2 gesendet werden kann. Im Gegenzug empfangen die Mess-/Steuergeräte 12 des ersten Transformators T1 und des dritten Transformators T3 keine Information vom Mess-/Steuergerät 12 des zweiten Transformators T2. Dies bedeutet, dass die beiden Mess-/Steuergeräte 12 des ersten Transformators T1 und des dritten Transformators T3 die Einstellung eines minimalen Kreisblindstroms weiter durchführen, ohne dabei die Werte des Mess-/Steuergeräts 12 des zweiten Transformators T2 zu berücksichtigen, da von diesem aufgrund der Unterbrechung 16 keine Messwerte geliefert werden.

Das Mess-/Steuergerät 12 des zweiten Transformators T2 führt das Verfahren zur Einstellung eines minimalen Kreisblindstroms weiter unter Verwendung der zuletzt übermittelten Werte der Mess-/Steuergeräte 12 des ersten Transformators T1 und des dritten Transformators T3 durch.

Der Vorteil der gegenwärtigen Erfindung ist, dass die Messwerte des durch die Unterbrechung 16 ausgefallenen Mess-/Steuergeräts 12 von den anderen Mess-/Steuergeräten 12 als konstant angenommen werden. Somit wird der Transformator, bei dem die Unterbrechung 16 des Mess-/Steuergeräts 12 auftritt, weiterhin im Parallellauf berücksichtigt. Dasjenige Mess-/Steuergerät 12, das keine Kommunikation zu anderen Mess-/Steuergeräten 12 mehr hat, nimmt die letzten Werte der anderen Mess-/Steuergeräten 12 als konstant an und führt die Methode der Kreisblindstromminimierung weiter durch. Mess-/Steuergeräte 12, welche noch eine Kommunikation zu mindestens einem anderen Mess-/Steuergerät 12 haben, führen die Methode der Kreisblindstromminimierung weiter und zwar nur mit den an der Kommunikation beteiligten Mess-/Steuergeräten 12.

In anderen Worten bedeutet dies im vorliegenden konkret beschriebenen Fall, dass der zweite (isolierte) Transformator T2 mit den letzten, mittels der Kommunikationsverbindung 14 übertragenen Messwerten über das dazugehörende Mess-/Steuergerät 12 gesteuert wird.

Mit der oben vorgeschlagenen und verbesserten Lösung (siehe **Figur 6**) sollte das Mess-/Steuergerät 12 am zweiten Transformator T2 nicht blockiert werden. In dem hier dargestellten Fall ist der Anteil an der Summe der Teilströme (der Blindstrom wie auch der Wirkstrom-Anteil) vom Mess-/Steuergerät 12 des ersten Transformators T1 und vom Mess-/Steuergerät 12 und des dritten Transformators T3 als konstant zu betrachten.

Infolge dessen wird eine Gefahr des Entstehens von Kreisblindströmen deutlich verringert, auch weil alle anderen Mess-/Steuergeräte 12 nach der gleichen Berechnungsvorschrift arbeiten können und eine partielle Dynamik des Regelkreises trotz der Unterbrechung erhalten bleibt.

Wie aus den obigen Gleichungen ersichtlich, fließen in die Berechnung von $\Delta U_{KBS}$ für den Fall der Unterbrechung der Kommunikationsverbindung 14 die von den Mess-/Steuergeräten 12 vor der Unterbrechung ermittelten Werte für Wirkstrom $I_W$ und Blindstrom $I_B$ mit ein. Diese Werte bleiben bis zur Wiederherstellung der Kommunikationsverbindung 14 konstant, so dass auch für die Zeitdauer der Unterbrechung die Summe $\sum I_W$ aller Wirkströme und die Summe $\sum I_B$ aller Blindströme berechnet werden kann.

Die Erfindung wurde in Bezug auf eine Ausführungsform beschrieben. Es ist für einen Fachmann selbstverständlich, dass Änderungen und Abwandlungen durchgeführt werden können, ohne dabei den Schutzbereich der nachstehenden Ansprüche zu verlassen.

**Patentansprüche**

1. Verfahren zur Parallellaufregelung von mehreren Transformatoren (T1, T2, ..., TN) in einer Parallelschaltung (10), wobei jedem der Transformatoren (T1, T2, ..., TN) ein Stufenschalter mit einem Mess-/Steuergerät (12) zugeordnet ist und alle Mess-/Steuergeräte (12) über eine Kommunikationsverbindung (14) miteinander verbunden sind; beinhaltend **die folgenden Schritte:**

   • dass zumindest ein Messwert des jeweiligen Mess-/Steuergeräts (12) der jeweiligen Transformatoren (T1, T2, ..., TN) über die Kommunikationsverbindung (14) an N-1 Mess-/Steuergeräte (12) übertragen wird;
   • dass an Hand der Messwerte der Mess-/Steuergeräte (12) eine Berechnung einer Regelabweichung, die von einem Kreisblindstrom verursacht wird, für jedes Mess-/Steuergerät (12) durchgeführt wird;
   • dass der jedem Transformator (T1, T2, ..., TN) zugeordnete Stufenschalter aufgrund der berechneten Regelabweichung durch das Mess-/Steuergerät (12) derart betätigt wird, dass eine Minimierung des Kreisblindstroms für den jeweiligen Transformator (T1, T2, ..., TN) durchgeführt wird;

   **gekennzeichnet dadurch,**

   • **dass** ein Fehlen mindestens eines Signals von mindestens einem Mess-/Steuergerät (12) durch eine Unterbrechung (16) der Kommunikationsverbindung (14) zu einem Zeitpunkt (t) hervorgerufen wird und dass das Fehlen des mindestens eines Signals von mindestens einem Mess-/Steuergerät (12) von allen übrigen Mess-/Steuergeräten (12) festgestellt wird;
   • **dass** die für eine Minimierung eines Kreisblindstroms erforderliche Regelabweichung mindestens eines von der Unterbrechung (16) der Kommunikationsverbindung (14) betroffenen Mess-/Steuergerätes (12) eines Transformators (T1, T2, ..., TN) an Hand der vor einem Zeitpunkt (t) über die Kommunikationsverbindung (14) empfangenen Messwerte, welche von dem zugeordneten Mess-/Steuergerät (12) von zumindest einem weiteren Transformator (T1, T2, ..., TN) übertragen wurden, ermittelt wird, wobei in die Ermittlung die eigenen, aktuell gemessenen Messwerte des von der Unterbrechung betroffenen Mess-/Steuergeräts (12) mindestens eines Transformators einfließen.

2. Verfahren nach Anspruch 1, wobei die an jedem Mess-/Steuergerät (12) der Parallelschaltung (10) gemessenen Messwerte der jeweiligen Transformatoren (T1, T2, ... , TN) jeweils ein sich mit der Zeit ändernder Wirkstrom ($I_{1W}$, $I_{2W}$, ..., $I_{NW}$) und ein sich mit der Zeit ändernder Blindstrom ($I_{1B}$, $I_{2B}$, ..., $I_{NB}$) sind.

3. Verfahren nach Anspruch 1, wobei die Mess-/Steuergeräte (12), die durch die Unterbrechung (16) der Kommunikationsverbindung (14) isoliert sind, für die Zeitdauer der Unterbrechung (16) in die Berechnung der erforderlichen Regelabweichung zur Minimierung des Kreisblindstroms die eigenen aktuell gemessenen Messwerte und die zum Zeitpunkt (t) der Unterbrechung als konstant geltenden Messwerte der übrigen Mess-/Steuergeräte (12) verwenden, so dass eine Dynamik der Parallellaufregelung der Parallelschaltung (10) aller Transformatoren (T1, T2, ..., TN) der Parallelschaltung (10) erhalten bleibt.

4. Verfahren nach Anspruch 3, wobei bei denjenigen Mess-/Steuergeräten (12), die weiterhin über die Kommunikationsverbindung (14) miteinander verbunden sind, für die Berechnung der erforderlichen Regelabweichung zur Minimierung des Kreisblindstroms die eigenen aktuell gemessenen Messwerte und die aktuell gemessenen Messwerte der übrigen, noch über die Kommunikationsverbindung (14) verbundenen Mess-/Steuergeräte (12) einfließen.

5. Verfahren nach Anspruch 3, wobei bei denjenigen Mess-/Steuergeräten (12), die weiterhin über die Kommunikationsverbindung (14) miteinander verbunden sind, für die Berechnung der erforderlichen Regelabweichung zur Minimierung des Kreisblindstroms die eigenen aktuell gemessenen Messwerte, die aktuell gemessenen Messwerte der übrigen, noch über die Kommunikationsverbindung (14) verbundenen Mess-/Steuergeräte (12) und die als konstant geltenden Messwerte der durch die Unterbrechung (16) der Kommunikationsverbindung (14) zum Zeitpunkt (t) als isoliert geltenden Mess-/Steuergeräte (12) einfließen.

6. Verfahren nach einem der voran stehenden Ansprüche, wobei die Anzahl der in einer Parallelschaltung (10) vorgesehenen Transformatoren (T1, T2, ..., TN) mindestens 2 und kleiner oder gleich 16 ist.

7. Verfahren nach einem der voran stehenden Ansprüche, wobei das über die Kommunikationsverbindung (14) übertragene Signal von den Mess-/Steuergeräten (12) aus einem Bereitschaftssignal des jeweiligen Mess-/Steuergeräts (12) und den Messwerten der jeweiligen Mess-/Steuergeräte (12) besteht.

8. Verfahren nach Anspruch 7, wobei das Fehlen des Bereitschaftssignals und/oder das Fehlen der Messwerte vom jeweiligen Mess-/Steuergerät (12) die Unterbrechung (16) anzeigen, wodurch das betroffene Mess-/Steuergerät (12) isoliert ist.

9. Verfahren nach einem der Ansprüche 7 oder 8, wobei das Bereitschaftssignal von den Mess-/Steuergeräten (12) mit einer höheren oder einer gleichen Frequenz als die Sendefrequenz der Messwerte von den Mess-/Steuergeräten (12) gesendet wird.

## Claims

1. Method of regulating parallel operation of a plurality of transformers (T1, T2, ..., TN) in a parallel circuit (10), wherein a tap changer with a measuring/control device (12) is associated with each of the transformers (T1, T2, ..., TN) and all measuring/control devices (12) are connected together by way of a communications connection (14), comprising the following steps:

   - at least one measurement value of the respective measuring/control device (12) of the respective transformers (T1, T2, ..., TN) is transferred by way of the communications connection (14) to N-1 measuring/control devices (12);
   - calculation of a regulating deviation, which is caused by a circuit reactive current, for each measuring/control device (12) is carried out on the basis of the measurement values of the measuring/control devices (12);
   - the tap changer associated with each transformer (T1, T2, ..., TN) is so actuated by the measuring/control device (12) as a function of the calculated regulating deviation that minimisation of the circuit reactive current is carried out for the respective transformer (T1, T2, ..., TN);

   **characterized by**

   - absence of at least one signal of at least one measuring/control device (12) is caused by interruption (16) of the communications connection (14) at an instant (t) and the absence of the at least one signal of at least one measuring/control device (12) is detected by all remaining measuring/control devices (12); and
   - the regulating deviation, which is required for minimisation of a circuit reactive current, of at least one measuring/control device (12), which is affected by the interruption (16) of the communications connection (14), of a transformer (T1, T2, ..., TN) is determined on the basis of the measurement values which were received by way of the communications connection (14) prior to the instant (t) and which were transferred from the associated measuring/control device (12) of at least one further transformer (T1, T2, ..., TN), wherein the individual instantaneously measured measurement values of the measuring/control device (12), which is affected by the interruption, of at least one transformer are included in the determination.

2. Method according to claim 1, wherein the measurement values, which are measured at each measuring/control device (12) of the parallel circuit (10), of the respective transformers (T1, T2, ..., TN) are each an active current ($I_{1W}$, $I_{2W}$, ..., $I_{NW}$) changing with time and a reactive current ($I_{1B}$, $I_{2B}$, ..., $I_{NB}$) changing with time.

3. Method according to claim 1, wherein the measuring/control devices (12) isolated by the interruption (16) of the communications connection (14) use, for the duration of the interruption (16), in the calculation of the required regulating deviation for minimisation of the circuit reactive current the individual instantaneously measured measurement values and the measurement values, which are regarded as a constant, at the instant (t) of the interruption, of the remaining measuring/control devices (12) so that a dynamic of the parallel operation regulation of the parallel circuit (10) of all transformers (T1, T2, ..., TN) of the parallel circuit (10) is maintained.

**4.** Method according to claim 3, wherein for those measuring/control devices (12) still connected together by way of the communications connection (14) the individual instantaneously measured measurement values and the instantaneously measured measurement values of the remaining measuring/control devices (12) still connected by way of the communications connection (14) are included for calculation of the required regulating deviation for minimisation of the circuit reactive current.

**5.** Method according to claim 3, wherein for those measuring/control devices (12) still connected together by way of the communications connection (14) the individual instantaneously measured measurement values, the instantaneously measured measurement values of the remaining measuring/control devices (12) still connected by way of the communications connection (14) and the measurement values, which are regarded as a constant, of the measuring/control devices (12) treated as isolated by the interruption (16) of the communications connection (14) at the instant (t) are included for calculation of the required regulating deviation for minimisation of the circuit reactive current.

**6.** Method according to any one of the preceding claims, wherein the number of transformers (T1, T2, ..., TN) provided in a parallel circuit (10) is at least two and less than or equal to sixteen.

**7.** Method according to any one of the preceding claims, wherein the signal, which is transferred by way of the communications connection (14), from the measuring/control devices (12) consists of a readiness signal of the respective measuring/control device (12) and the measurement values of the respective measuring/control devices (12).

**8.** Method according to claim 7, wherein the absence of the readiness signal and/or the absence of the measurement values from the respective measuring/control device (12) indicates or indicate the interruption (16), whereby the affected measuring/control device (12) is isolated.

**9.** Method according to one of claims 7 and 8, wherein the readiness signal is transmitted from the measuring/control devices (12) at a frequency higher than or equal to the transmission frequency of the measurement values from the measuring/control devices (12).

**Revendications**

**1.** Procédé de régulation du fonctionnement en parallèle de plusieurs transformateurs (T1, T2, ..., TN) dans un montage en parallèle (10), à chacun des transformateurs (T1, T2, ..., TN) étant associé un commutateur à gradins équipé d'un appareil de mesure / commande (12) et tous les appareils de mesure / commande (12) étant reliés par une liaison de communication (14),
comprenant les étapes suivantes selon lesquelles :

- au moins une valeur de mesure de chaque appareil de mesure / commande (12) de chaque transformateur (T1, T2, ..., TN) est transmise par la liaison de communication (14) à N-1 appareils de mesure / commande (12),
- à partir des valeurs de mesure des appareils de mesure / commande (12) un calcul d'un écart de réglage qui est provoqué par un courant réactif est effectué pour chacun des appareils de mesure / commande (12),
- le commutateur à gradins associé à chaque transformateur (T1, T2, ..., TN) est actionné par l'appareil de mesure / commande (12) sur le fondement de l'écart de réglage calculé de façon à minimiser le courant réactif pour chacun des transformateurs (T1, T2, ..., TN),

**caractérisé en ce qu'**

- une absence d'au moins un signal d'au moins un appareil de mesure / commande (12) est provoquée par une interruption (16) de la liaison de communication (14) à un instant (t), et l'absence du signal d'au moins un appareil de mesure / commande (12) est constatée par tous les autres appareils de mesure / commande (12),
- l'écart de réglage nécessaire pour minimiser le courant réactif d'au moins l'un des appareils de mesure / commande (12) d'un transformateur (T1, T2, ..., TN) concerné par l'interruption (16) de la liaison de communication (14) est déterminé sur le fondement des valeurs de mesures reçues avant l'instant (t) par la liaison de communication (14) qui ont été transmises par l'appareil de mesure / commande (12) associé d'au moins un autre transformateur (T1, T2, ..., TN) lors de la détermination, les valeurs de mesure propres actuellement mesurées de l'appareil de mesure / commande (12) d'au moins un transformateur concerné par l'interruption ayant une influence.

**2.** Procédé conforme à la revendication 1,
selon lequel les valeurs de mesure des transformateurs (T1, T2, ..., TN) respectifs mesurées sur chaque appareil de mesure / commande (12) du montage en parallèle (10) sont respectivement un courant efficace ($I_{1W}$, $I_{2W}$,..., $I_{NW}$) variable en fonction du temps et un courant réactif ($I_{1B}$, $I_{2B}$, ..., $I_{NB}$) variable en fonction du temps.

**3.** Procédé conforme à la revendication 1,
selon lequel les appareils de mesure / commande (12) qui sont isolés par l'interruption (16) de la liaison de communication (14) utilisent, pensant la durée de l'interruption (16), pour le calcul de l'écart de réglage nécessaire pour minimiser le courant réactif, les valeurs de mesure propres actuellement mesurées et les valeurs de mesure des autres appareils de mesure / commande (12) en cours en tant que constantes à l'instant (t) de l'interruption, de sorte que la dynamique de la régulation du fonctionnement en parallèle du montage en parallèle (10) de tous les transformateurs (T1, T2, ..., TN) du montage en parallèle (10) demeure.

**4.** Procédé conforme à la revendication 3,
selon lequel dans le cas des appareils de mesure / commande (12) qui continuent à être reliés par la liaison de communication (14), pour le calcul de l'écart de réglage nécessaire pour minimiser le courant de réaction, les valeurs de mesure propres actuellement mesurées et les valeurs de mesure actuellement mesurées des autres appareils de mesure / commande (12) encore reliés par la liaison de communication (14) ont une influence.

**5.** Procédé conforme à la revendication 3,
selon lequel dans le cas des autres appareils de mesure / commande (12) qui contribuent à être reliés par la liaison de communication (14), pour le calcul de l'écart de réglage nécessaire pour minimiser le courant de réaction, les valeurs de mesure propres actuellement mesurées, les valeurs de mesure actuellement mesurées des autres appareils de mesure / commande (12) encore reliées par l'intermédiaire de la liaison de communication (14) et les valeurs de mesure en cours en tant que constantes à l'instant (t) des appareils de mesure / commande (12) isolés par l'interruption (16) de la liaison de communication (14).

**6.** Procédé conforme à l'une des revendications précédentes,
selon lequel le nombre de transformateurs (T1, T2, ..., TN) montés dans le montage en parallèle (10) est au moins égal à 2 et inférieur ou égal à 16.

**7.** Procédé conforme à l'une des revendications précédentes,
selon lequel le signal des appareils de mesure / commande (12) transmis par l'intermédiaire de la liaison de communication (14) est constitué par un signal de veille de l'appareil de mesure / commande (12) respectif et les valeurs de mesure des appareils de mesure / commande (12) respectifs.

**8.** Procédé conforme à la revendication 7,
selon lequel l'absence de signal de veille et/ou l'absence des valeurs de mesure des appareils de mesure / commande (12) respectifs indique(nt) l'interruption (16), l'appareil de mesure / commande (12) concerné étant isolé.

**9.** Procédé conforme à l'une des revendications 7 à 8,
selon lequel le signal de veille des appareils de mesure / commande (12) est émis avec une fréquence supérieure ou égale à la fréquence d'émission des valeurs de mesure par les appareils de mesure / commande (12).

Fig. 1

**Stand der Technik**

Fig. 2

Ermitteln der Messwerte für den Wirkstrom und für den Blindstrom mit den Mess-/Steuereinrichtungen und Übermitteln an alle Mess-/Steuereinrichtungen — 100

Zyklisches Sammeln und Auswerten der Messwerte aller parallel geschalteten Transformatoren — 200

Bestimmen des Winkels des Vektors aus Gesamtwirkstrom und Gesamtblindstrom in Bezug auf die Wirkstromachse — 300

Ermitteln des eigenen Sollblindstroms $I_{i\,BSoll}$ aus dem eigenen Wirkstrom $I_{i\,W}$ und dem Verhältnis aus der Summe $I_W$ aller Wirkströme und der Summe $I_B$ aller Blindströme, i = 1, ..., N — 400

Berechnung des eigenen Kreisblindstroms $I_{i\,B\_KBS}$ jedes Spannungsreglers aus dem berechneten Sollblindstrom $I_{i\,B\_SOLL}$ und dem eigenen Blindstrom $I_{i\,B}$, i = 1, ..., N — 500

Umwandeln des Kreisblindstroms in eine Spannungsdifferenz — 600

**Stand der Technik**

**Fig. 3**

Fig. 4

Fig. 5

**Fig. 6**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2389723 A2
- WO 9317480 A1
- EP 0482361 A2

- DE 4004671 C1
- DE 10039918 A1
- DE 102008053193 A1